# EUROPEAN PATENT APPLICATION

(11) **EP 2 246 914 A1**
(43) Date of publication of application: **03.11.2010**
(21) Application number: 10161328.9
(22) Date of filing: 28.04.2010
(51) Int. Cl.: H01L 35/30, H01L 35/32, H01L 35/22, H01L 31/058

(54) **A unit for converting solar energy and/or thermal energy into electric power**

(30) Priority: 28.04.2009 IT MO20090101
(71) Applicant: Solution e Partners S.r.l., 35042 Este (PD) (IT)
(72) Inventor: Capuzzi, Emidio, 35043, Monselice PD (IT); Pieragostini, Enrico, 37121, Verona (IT); Patorno, Luciano, 41121, Modena (IT); Sighinolfi, Sergio, 41124, Modena (IT)
(74) Representative: Modiano, Micaela Nadia

(57) **Abstract**

A unit for converting solar energy and/or thermal energy into electric power, which comprises a structure (101) for supporting a plurality of elements that collect the solar energy and/or thermal energy to be converted, which are at least mutually connected functionally, and comprises means (103) for recovering thermal energy released by the collecting elements, the means being heated by them and being associated with the supporting structure (102), comprising:
at least one shimmed element (104) with a first end (105) that is associated with the recovery means (103) and a second end (106) that lies opposite the first end (105) and is associated with cooling means (107) in order to obtain a thermal gradient between the ends; the shimmed element (104) comprising a PNP material of the type of junctions at least of metallic oxides and/or alloys, which comprise at least one among the elements comprised in the group of magnesium, copper, aluminum, gold and elements with electrochemical potential that are similar to them, interposed between the ends (105, 106) and adapted to emit an electromotive force in order to recover and make available electric power from the temperature difference between the first and second ends (105, 106).

## Description

The present invention relates to a unit for converting solar energy and/or thermal energy into electric power.

As is known to the person skilled in the art, photovoltaic panels, used for converting solar energy into electric power, are constituted by a plurality of photovoltaic cells which are mutually connected electrically.

Each one of these photovoltaic cells is constituted in turn by a semiconductor, generally silicon, conveniently doped, generally with boron and phosphorus, so as to obtain a p layer (characterized by an excess of holes and thus of positive charges) and an n layer (characterized by an excess of electrons and thus of negative charges).

An accumulation of charges of opposite sign, and thus an electric field, is created which straddles the p-n junction region that separates such two layers.

The incidence of sunlight on the photovoltaic cells, particularly on their n layer, causes a displacement of electrons and of holes in opposite directions and thus the circulation of electrical current.

Generally, known photovoltaic cells use only the sunlight that strikes directly their n layer, since they are arranged mutually laterally adjacent so that one face (which corresponds to the respective n layer) is directed toward the sun, and therefore is struck directly by the rays of the sun, and one face (which corresponds to the respective p layer) instead is not reached in a direct manner by the rays of the sun.

Currently, photovoltaic cells use only the solar energy that strikes the respective n layers.

Moreover, the power emitted by each individual photovoltaic cell varies through the day because the intensity and the wavelength of the incident light varies.

In order to improve the sunlight collection time and the power that can be obtained from photovoltaic cells, such cells are treated with two methods disclosed in Italian patent applications RM2003A000147 and VR2007A000148.

Moreover, as is known, photovoltaic panels exposed to solar radiation are subjected to heating, which derives mainly from direct exposure and from the Joule effect on the photovoltaic cells. As is known, this thermal energy can be used for heating water or the like or enclosed spaces.

Moreover, direct thermal collection systems are known which therefore seek to use the thermal energy that results from solar exposure of panels that can be of a photovoltaic type or simple heat collection panels to use such thermal energy as mentioned above.

Finally, it is known to utilize the thermal energy that derives from combustion processes, for example by means of heat exchangers that absorb heat from exhaust gases, vapors and others and make it available for heating enclosed spaces, water and the like.

These known devices, for example in the case of utilization of the thermal energy that derives from photovoltaic panels, have a low efficiency.

The aim of the present invention is to eliminate the drawbacks mentioned above of the background art, by devising a unit for converting solar energy and/or thermal energy into electric power that has high conversion efficiencies in order to convert a high percentage of solar energy and/or thermal energy that derives from said solar and/or thermal exposure that derives from any heat generation process into electric power to be made available and usable.

Within this aim, an object of the invention is to increase remarkably the performance of conversion of solar/thermal energy into electric power with respect to known systems by maintaining an apparatus structure that is relatively compact and light in order to provide photovoltaic panels that are easy to install and to use.

Another object of the present invention is to devise a conversion unit that is simple, relatively easy to provide in practice, safe in use, effective in operation, and of relatively low cost.

This aim and these and other objects that will become better apparent hereinafter are achieved by the present unit for converting solar energy and/ or thermal energy into electric power, which comprises a structure for supporting a plurality of elements that collect the solar energy and/or thermal energy to be converted, which are at least mutually connected functionally, and comprises means for recovering thermal energy released by said collecting elements, said means being heated by them and being associated with said supporting structure, **characterized in that** it comprises:
at least one shimmed element with a first end that is associated with said recovery means and a second end that lies opposite said first end and is associated with cooling means in order to obtain a thermal gradient between said ends; said shimmed element comprising a PNP material of the type of junctions at least of metallic oxides and/or alloys, which comprise at least one among the elements comprised in the group of magnesium, copper, aluminum, gold and elements with electrochemical potential that are similar to them, interposed between said ends and adapted to emit an electromotive force in order to recover and make available electric power from the temperature difference between said first end and said second end.

Further characteristics and advantages of the present invention will become better apparent from the following detailed description of some preferred but not exclusive embodiments of a unit for converting solar energy and/or thermal energy into electric power, illustrated in the accompanying drawings, wherein:
Figure 1 is a schematic top view of a unit for converting solar energy and/or thermal energy into electric power, in the specific case a photovoltaic panel, according to the invention;
Figure 2 is a sectional side view of Figure 1, taken along the sectional plane II-II;
Figure 3 is a view of a detail of Figure 2;
Figure 4 is a sectional front view of Figure 1, taken along the sectional plane IV-IV;
Figure 5 is a bottom view of Figure 1;
Figure 6 is a schematic top view of an alternative embodiment of a unit for converting solar energy and/or thermal energy into electric power, in the specific case a photovoltaic panel, according to the invention;
Figure 7 is a sectional side view of Figure 6, taken along the sectional plane VII-VII;
Figure 8 is a view of a detail of Figure 7;
Figure 9 is a sectional front view of Figure 6, taken along the sectional plane IX-IX;
Figure 10 is a bottom view of Figure 6;
Figure 11 is a view of a detail of Figure 9.

The present invention relates to a unit for converting solar energy and/or thermal energy into electric power that comprises a plurality of collecting elements, for example photovoltaic cells or heat accumulation elements, which are at least mutually connected functionally, for example respectively connected electrically or thermally linked.

Moreover, the conversion unit comprises means for recovering the thermal energy released by the collecting elements, for example by the photovoltaic cells or by heating due to exposure to heat sources of the collecting element itself.

Reference is made hereinafter to the specific figures provided, in which the collecting elements are of the type of photovoltaic cells 1 and the unit is, therefore, a photovoltaic panel 100; however, different applications are not excluded, for example in systems for purely thermal recovery and the like.

The cell 1 comprises at least one layer of semiconductor material that is doped in order to provide a p-n junction. A first face 2 of the layer rests on on at least one structure 3 for containment of the layer.

A photovoltaic panel 100 is provided by way of a plurality of photovoltaic cells 1 which are mutually connected electrically and mutually jointly associated by means of the containment structure 3.

The panel 100 comprises a supporting structure 101, which has a protective glass 102 in the region affected by the cells 1 of a plurality of cells 1 mutually connected electrically as is known to the person skilled in the art.

The cells 1, due to irradiation, besides making available electric power, become warm due to the Joule effect caused by the heat dissipation of the electrical connections and by simple exposure to the rays of the sun.

The panel 100 comprises means 103 for recovering the thermal energy released by the cells 1, which are warmed by such cells and are associated with the supporting structure 101.

For example, the recovery means 103 comprise a chamber in which a fluid flows which has been heated by the thermal recovery energy generated by the cells 1 and which is associated in a lower region with such cells.

According to the invention, the energy conversion unit comprises at least one shimmed element 104, for example a plate-like panel, which has a first end 105 (which corresponds to one face of the plate-like panel) which is associated with the thermal energy recovery means 103 and a second end 106 (which corresponds to the other face of the plate-lake panel) that lies opposite the first end 105 and is associated with cooling means 107 in order to obtain a thermal gradient between the two ends 105 and 106.

The shimmed element 104 further comprises a PNP material, for example in the form of pillars 108 that connect the first end and the second end, particularly of the type of junctions of metallic alloys, interposed between the first end and the second end, respectively 105 and 106, and adapted to emit an electromotive force in order to recover and make available electric power from the temperature difference between the first and second ends 105, 106.

The recovery of electric power starting from the thermal gradient between the first end and the second end is based on the so-called Seebeck effect, by using material that is sensitive to the thermal difference in terms of electrochemical semi-element potential, conveniently studied in an appropriately manner according to the boundary conditions of the conversion unit.

In one possible embodiment, the shimmed element 104 is constituted by a substantially plate-like panel that has two mutually opposite faces 105 and 106, that correspond to the ends of the shimmed element, between which a layer or a pillar of alloy and/or oxides of magnesium (Mg), joined to a layer or pillar of alloy and/or oxides of copper (Cu) or aluminum (Al) or gold (Au) is interposed.

Advantageously, the first and second faces, respectively 105 and 106, of the shimmed element 104 are made of at least one metallic material that is heat-resistant and chemically stable over time.

Advantageously, the use of this plate-like panel allows to recover, in the form of electric power made available to the unit, significant percentages of thermal energy, for example at least equal to or greater than 30% of the power of the cell 1.

Particularly, in optimum operating conditions it is possible to reach percentages of recovered thermal energy that are substantially equal to 45% of the power of the cell 1.

In order to keep the temperature difference between the first end and the second end, respectively 105 and 106, as great as possible, the cooling means 107 of the second end 106 (which is not exposed to the rays of the sun or to the source of heat) are of the fluid type, for example based on water or air.

The thermal energy recovery means 103 can be constituted, for example, also by a coil, embedded in a layer of transparent gel, which contains water or glycol or another liquid and is arranged proximate to the cells, at the part of the cells that is not exposed to the rays of the sun. The water that is present inside the coil therefore absorbs part of the thermal energy dissipated by the cells 1 and thus increases its temperature.

The first face 105 of the plate-like panel thus makes contact with such coil and is warmed and kept at a higher temperature that derives from exposure to the rays of the sun and from the secondary heating effects, for example from the Joule effect.

The second face 106, instead, is in contact with the cooling means 107, which lower its temperature with respect to the temperature of the water contained in the coil itself, thus obtaining a temperature difference between the two faces 105 and 106 of the plate-like panel 104.

Advantageously, the supporting structure 101 is of the type of a box-like body, the cells 1, the recovery means 103, the cooling means 107 and the shimmed element 104 being associated internally with respect to such supporting structure.

Advantageously, the cell 1 can be of the type of a lenticular photovoltaic cell, comprising a lens 4 as described in patent application No. MO2009A000103 in the name of this same Applicant and entitled "Lenticular photovoltaic cell".

Advantageously, the supporting structure 101 can be made of at least one material that is substantially transparent to solar radiation.

In particular, the supporting structure 101 is made of Perspex®, particularly as regards the protective glass 102 and its opposite surface 109, which forms the bottom of the box-like body of the supporting structure 101.

The supporting structure 101 is particularly adapted, for example, for use in modular structures in which in some situations, for example of particular inclination of the plurality of photovoltaic panels 100, one of them is in the shadow of another one. The solution of providing the supporting structure 101 of the photovoltaic panel, and in particular the surface 109 that lies opposite the collection surface formed by the supporting glass 102 (where the cells or other collecting medium are arranged), by using a transparent material allows the lighting of any photovoltaic panels 100 located behind.

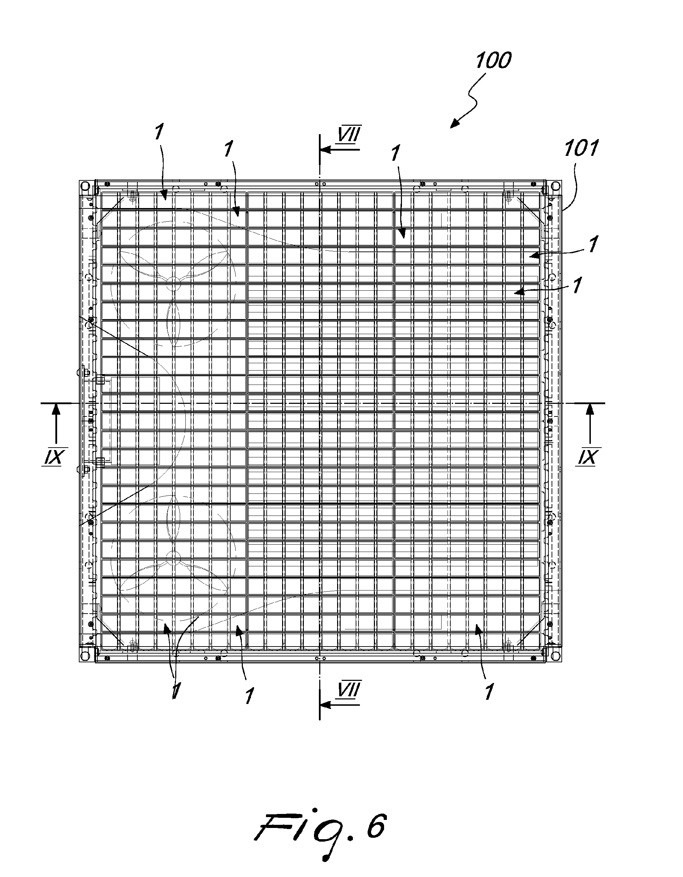

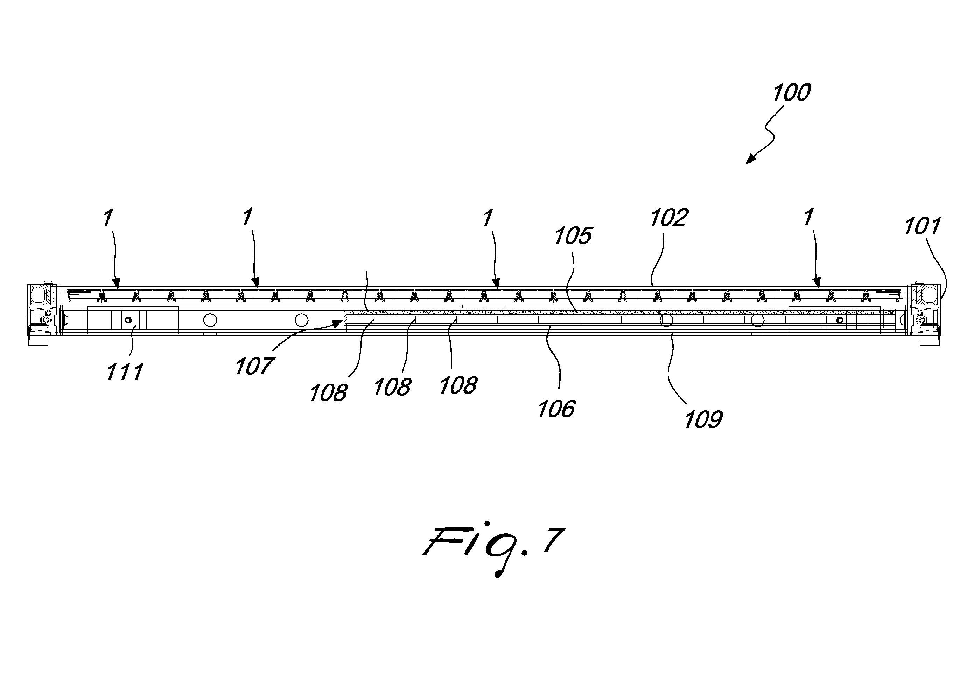

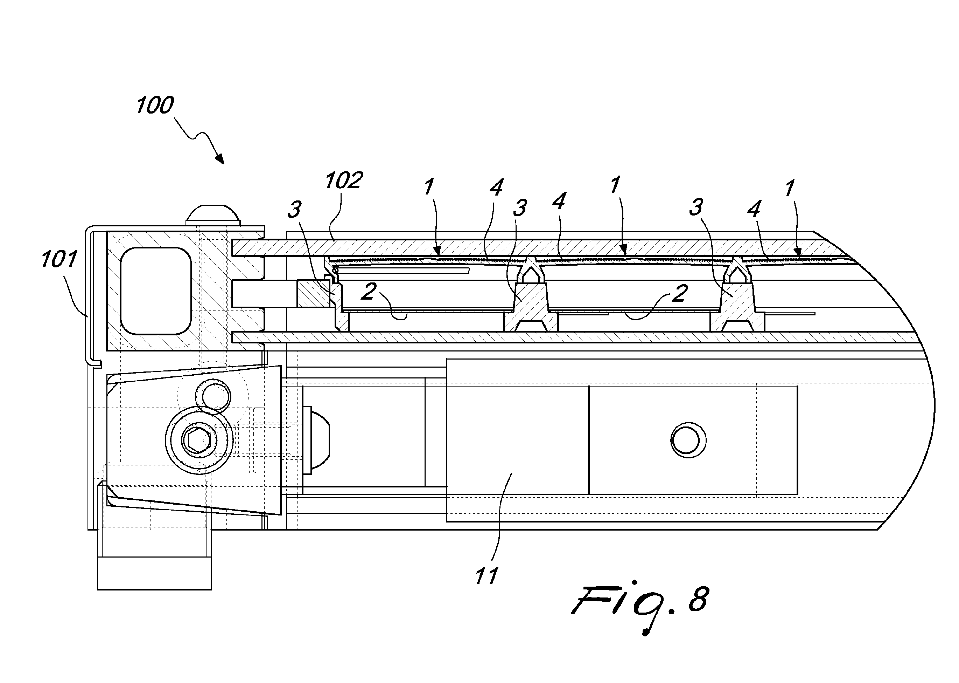

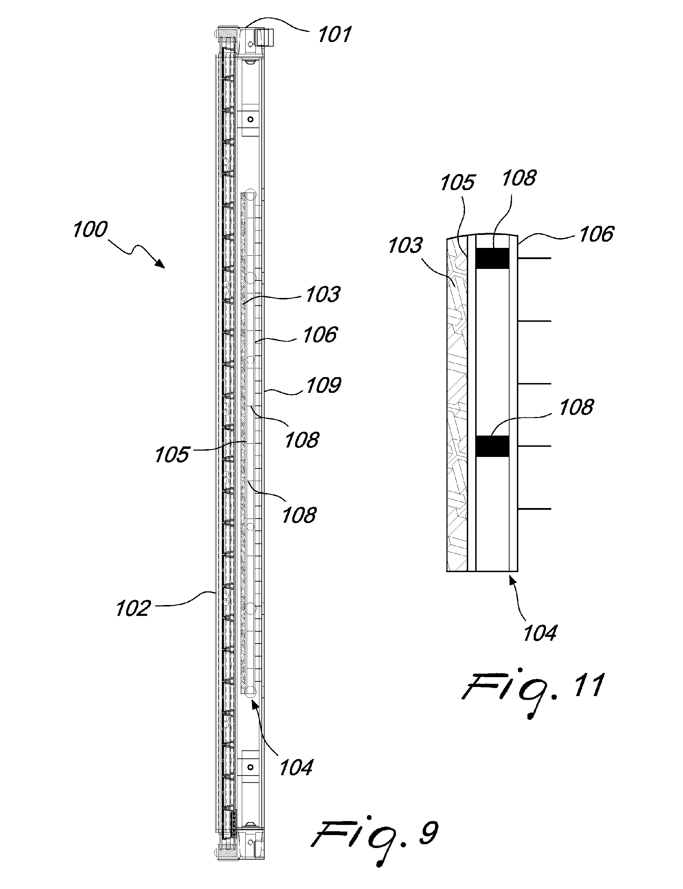

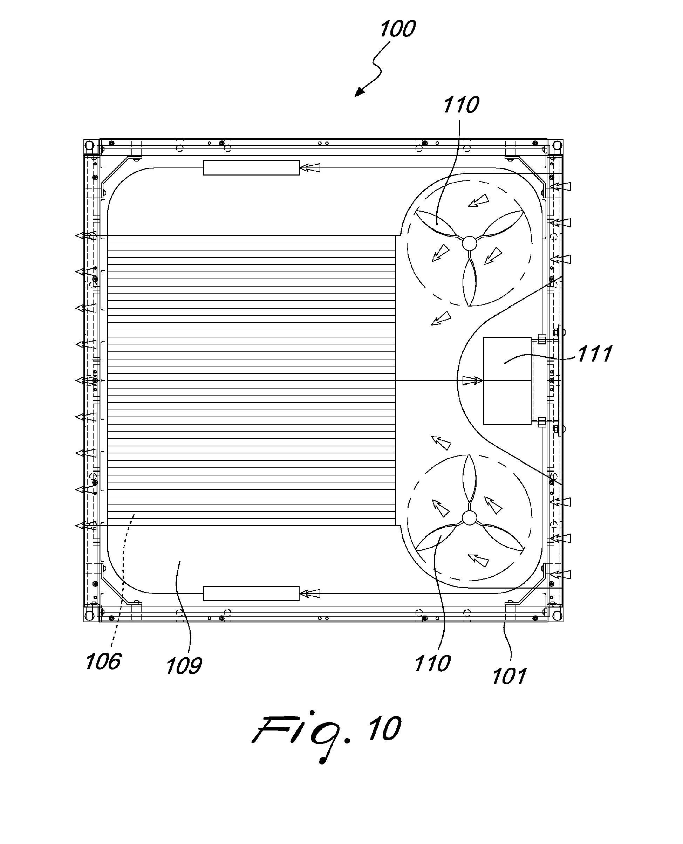

Moreover, if the cooling means 107 are of the air-based type, as shown in Figures 6 to 10, they comprise at least one fan 110 arranged proximate to the opposite surface 109, and thus on the back of the photovoltaic panel 100 at the side of the panel that is not exposed to the rays of the sun, in order to remove heat by ventilation from the second face 106 of the plate-like panel 104 that is not exposed to the rays of the sun.

In this last embodiment, the recovery means 103 and therefore the cooling means 107 can comprise a system for filtering the cooling fluid, i.e., the air propelled by the fans, that ensures its operation in optimum conditions.

In particular, the filtering system comprises at least one filtering device of the electrostatic type for collecting and removing the particulate suspended in the air without thereby requiring interventions for mechanical removal.

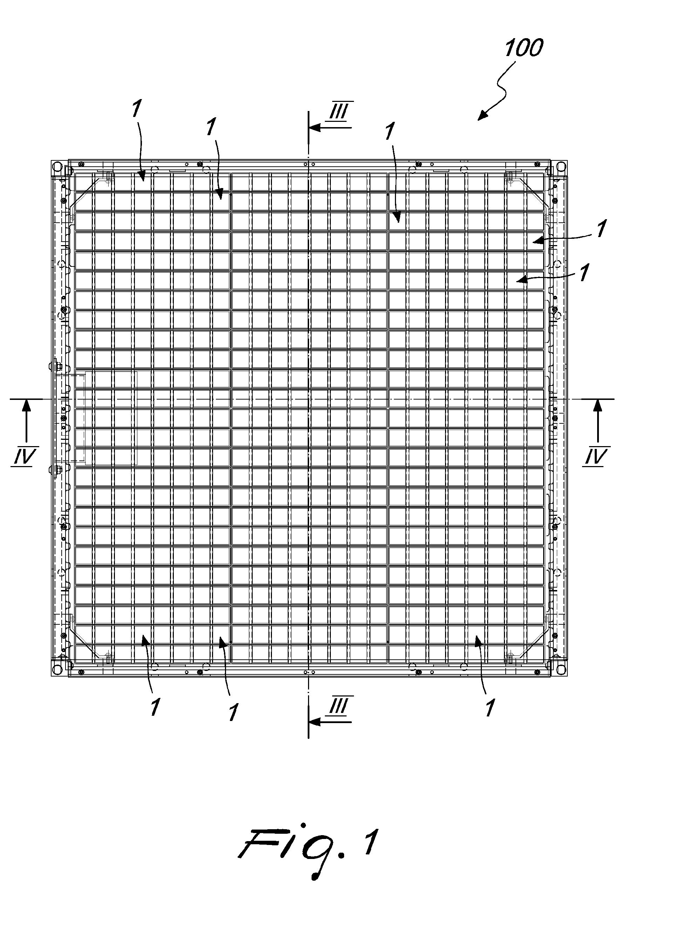

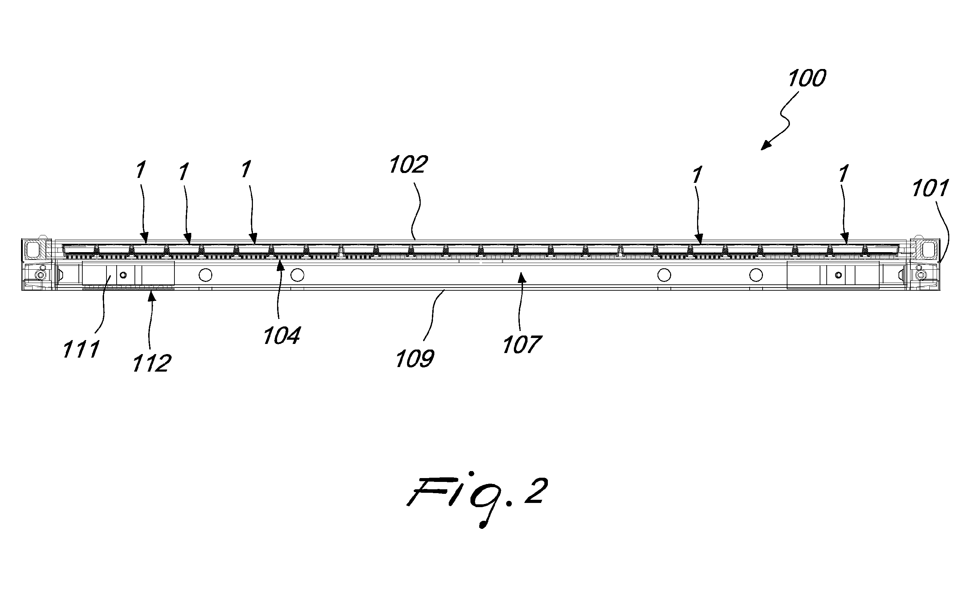

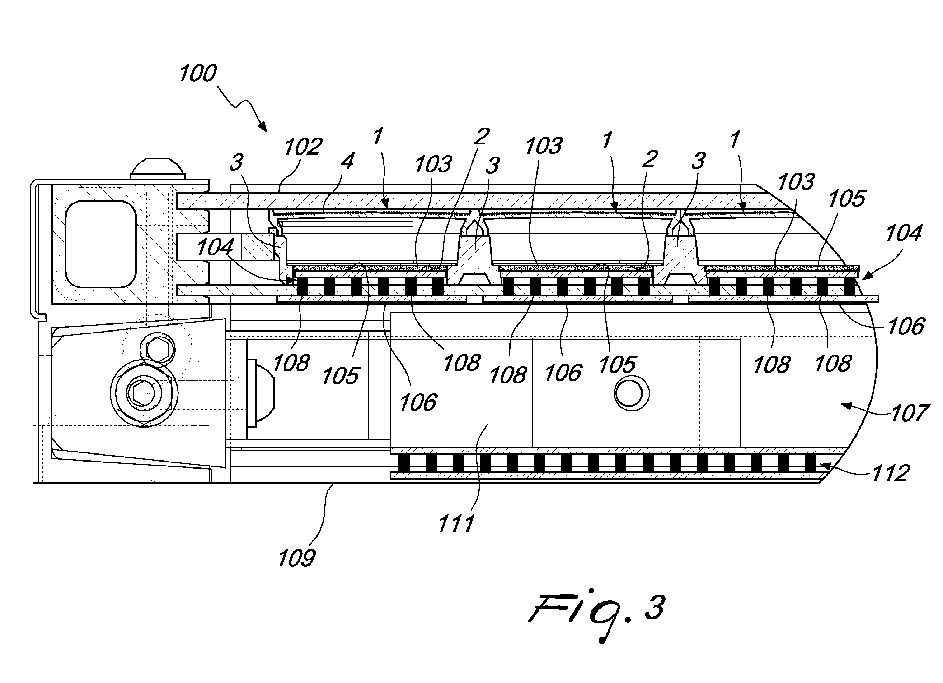

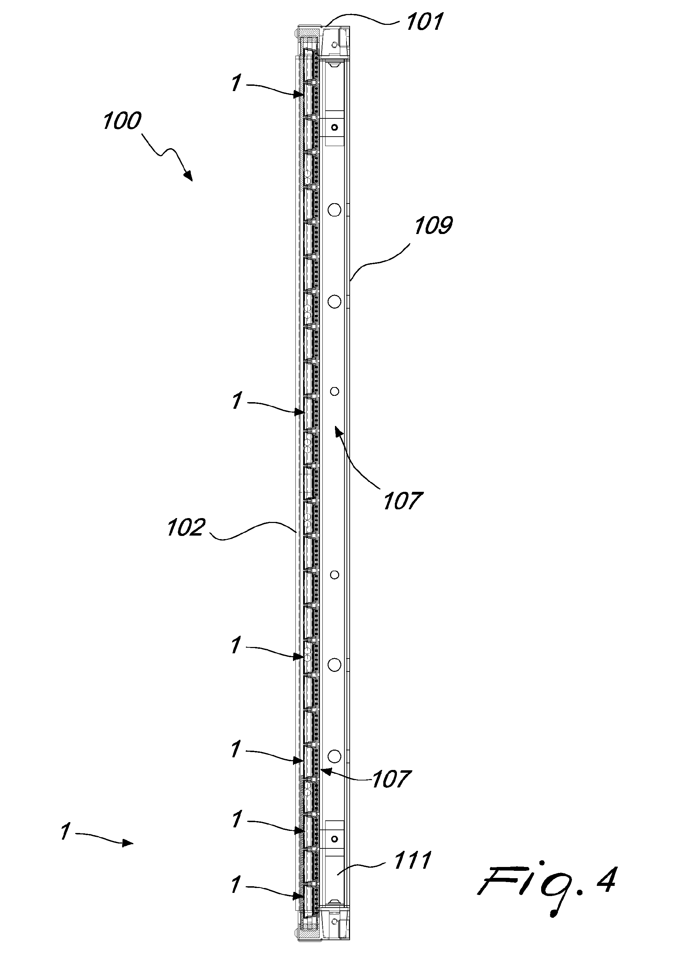

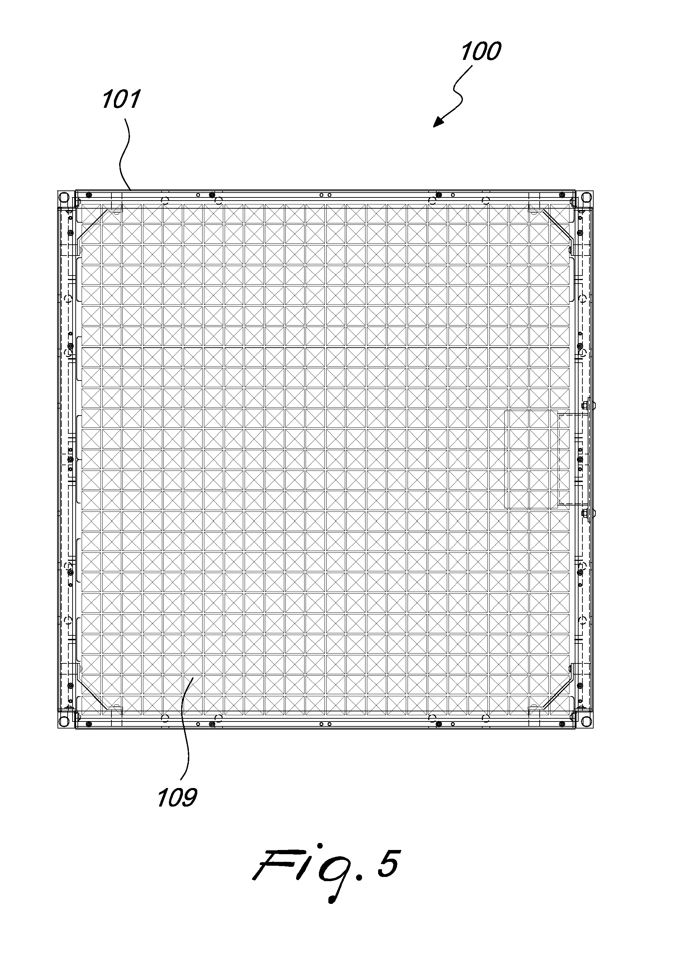

The cooling means 107 and the shimmed element 104 can be associated directly with each individual panel 100 (as shown in Figures 6 to 10), forming therewith a monolithic body. For medium to large apparatuses, the cooling means 107 might be centralized and controlled by the entire unit of photovoltaic panels 100; moreover, for small apparatuses the cooling means 107 might be "customized" and controlled by each individual cell 1 of the photovoltaic panel 100, as shown in Figures 1 to 5.

Possible applications of the invention are particularly advantageous for the utilization of the thermal energy produced by photovoltaic panels (secondary heating due to solar exposure and to the Joule effect on the cells), by thermal panels (primary heating due to solar exposure), but also by any heat source not due to solar exposure, such as for example hot gases or vapors that derive from combustion processes and the like, and the conversion thereof into electric power to be made available for use.

The unit comprises at least one inverter 111 in order to convert the converted DC electric power in AC electric power in order to supply it to the electrical grid.

Moreover, the unit can comprise a second shimmed element 112 as described above, arranged so that one of its faces faces and is adjacent to the opposite surface 109 and the other face faces the inverter 111 for the conversion of the thermal gradient between the two faces into available electric power, by means of the above mentioned Seebeck effect.

The invention thus conceived is susceptible of numerous modifications and variations, all of which are within the scope of the appended claims.

All the details may further be replaced with other technically equivalent elements.

In practice, the materials used, as well as the contingent shapes and dimensions, may be any according to requirements without thereby abandoning the protective scope of the appended claims.

The disclosures in Italian Patent Application No. M02009A000101, from which this application claims priority, are incorporated herein by reference.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. A unit for converting solar energy and/or thermal energy into electric power, which comprises a structure (101) for supporting a plurality of elements that collect the solar energy and/or thermal energy to be converted, which are at least mutually connected functionally, and comprises means (103) for recovering thermal energy released by said collecting elements, said means being heated by them and being associated with said supporting structure (102), **characterized in that** it comprises:
at least one shimmed element (104) with a first end (105) that is associated with said recovery means (103) and a second end (106) that lies opposite said first end (105) and is associated with cooling means (107) in order to obtain a thermal gradient between said ends; said shimmed element (104) comprising a PNP material of the type of junctions at least of metallic oxides and/or alloys, which comprise at least one among the elements comprised in the group of magnesium, copper, aluminum, gold and elements with electrochemical potential that are similar to them, interposed between said ends (105, 106) and adapted to emit an electromotive force in order to recover and make available electric power from the temperature difference between said first end and said second end.

2. The unit according to claim 1, **characterized in that** said first end (105) comprises at least one first substantially flat face that faces said recovery means (103) and is heated by them, said first face being made of at least one metallic material, and said second end (106) comprising at least one second face that faces said cooling means and is cooled by them, said second face being made of at least one metallic material, between said first face and said second face (105, 106) there being interposed a plurality of pillars (108), made of said PNP material, for junction between said faces.

3. The unit according to claims 1 or 2, **characterized in that** said supporting structure (101) is of the type of a box-like body, said collecting elements, said recovery means (103), said cooling means and said shimmed element (105) being associated internally with respect to said supporting structure (101).

4. The unit according to one or more of the preceding claims, **characterized in that** said supporting structure (101) is made substantially of at least one material that is transparent to the rays of the sun.

5. The unit according to claim 4, **characterized in that** said transparent material is of the type of Perspex^{®}.

6. The unit according to claim 1, **characterized in that** said cooling means (107) are of the fluid-based type.

7. The unit according to one or more of the preceding claims, **characterized in that** it comprises at least one system for filtering said fluid, said filtering system comprising at least one electrostatic filtering device for collecting and removing any particulate suspended in said fluid.
